# EUROPÄISCHE PATENTSCHRIFT

(11) **EP 0 710 985 B1**
(45) Veröffentlichungstag und Bekanntmachung des Hinweises auf die Patenterteilung: **25.03.1998**
(21) Anmeldenummer: 95116643.8
(22) Anmeldetag: 23.10.1995
(51) Int. Cl.: H01L 27/146

(54) **Röntgenbildsensor**
X-ray image sensor
Capteur de rayons X

(30) Priorität: 03.11.1994 DE 4439260; 31.01.1995 DE 19503034
(43) Veröffentlichungstag der Anmeldung: 08.05.1996
(73) Patentinhaber: SIEMENS AKTIENGESELLSCHAFT, 80333 München (DE)
(72) Erfinder: Sklebitz, Hartmut, Dipl.-Ing., D-91056 Erlangen (DE)

(56) Entgegenhaltungen:
- EP-A- 0 296 737
- EP-A- 0 597 725
- WO-A-91/15785
- US-A- 5 138 642

## Beschreibung

Röntgenbilder können durch einen Röntgenbildsensor angefertigt werden, der einen flächenhaften elektronischen Bildwandler (z.B. ein CCD) aufweist, dem ein Szintillator als Leuchtschirm vorgeschaltet ist. Der Bildwandler wird dabei optisch am Szintillator angekoppelt und erzeugt Bildsignale, aus denen ein Bild des untersuchten Bereiches eines Patienten elektronisch generiert werden kann. Die heute realisierbaren Bildwandler haben jedoch limitierte Abmessungen, so daß große Objekte dadurch nur durch aufwendige konstruktive Gestaltung, insbesondere der das Licht vom Szintillator auf den Bildwandler leitenden Fiberoptik erfaßt werden können.

In US-A-5 138 642 ist ein Bilddetektor beschrieben, der einen Röntgenbildverstärker aufweist, dem eine Fiberoptik mit senkrecht zum Ausgangsleuchtschirm verlaufenden Fasern zugeordnet ist. Am Ausgang der Fiberoptik sind weitere Faserbündel angeordnet, die das Licht zu CCD-Wandlern übertragen und die schräggestellt sein können. Diese Faserbündel setzen die Fiberoptik fort. Die CCD-Wandler sind mit Abstand zueinander angeordnet.

Der Erfindung liegt die Aufgabe zugrunde, einen Röntgenbildsensor auf der Basis von elektronischen Bildwandlern so zu gestalten, daß bei einfachem konstruktivem Aufbau eine relativ große Bildfläche geschaffen wird.

Diese Aufgabe ist erfindungsgemäß gelöst durch die Merkmale des Patentanspruches 1. Bei dem erfindungsgemäßen Röntgenbildsensor grenzen z.B. mehrere CCD-Bildwandler aneinander, wobei die optisch nicht aktiven Randzonen, in denen z.B. Gate-Anschlüsse und Register liegen, keine Lücken im Röntgenbild verursachen.

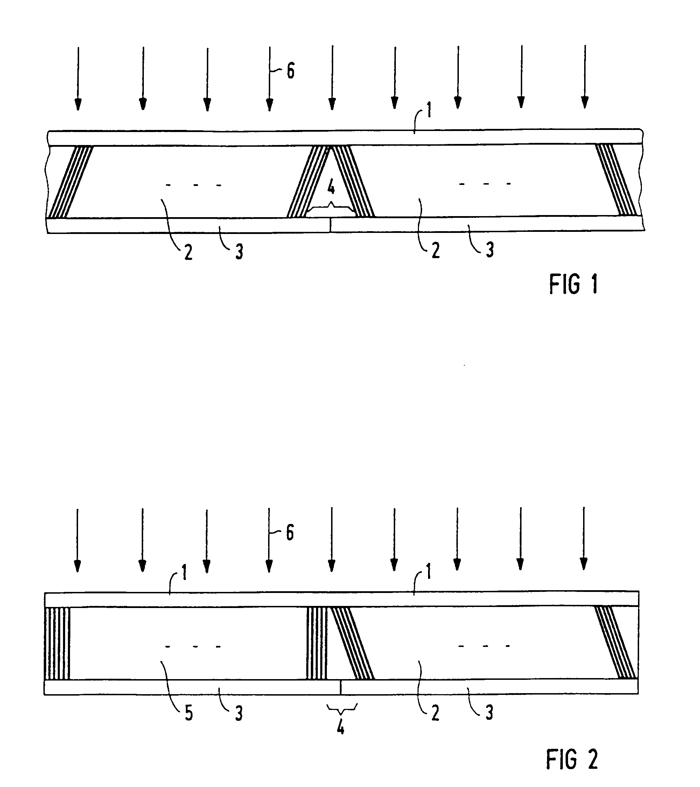

Die Erfindung ist nachfolgend anhand von drei in den Fig. 1 bis 3 dargestellten Ausführungsbeispielen näher erläutert.

In der Fig. 1 ist ein Szintillator 1 dargestellt, der mit Hilfe von Fiberoptiken 2 an Bildwandlern 3 optisch angekoppelt ist. Die Zeichnung zeigt, daß mehrere Bildwandler 3 in einer Fläche aneinander angrenzen. Sie weisen optisch nicht aktive Randzonen 4 auf. Damit dadurch keine Bildausfälle verursacht werden, sind die Fiberoptiken 2 unter einem von 90° abweichenden Winkel gegenüber den Bildwandlern 3 und dem Szintillator 1 geneigt. Sie grenzen dabei am Szintillator 1 aneinander an, erfassen also das gesamte Bild des Szintillators 1, lassen jedoch die Randzonen 4 der Bildwandler 3 frei.

Die Fiberoptiken 2 bestehen aus Bündeln paralleler Fasern, die unter einem von 90° abweichenden Winkel zur Faserachse stirnseitig abgeschnitten sind. Sie sind so zwischen die >Bildwandler 3 und den Szintillator 1 gelegt, daß sie am Szintillator 1 aneinander angrenzen, die Randzonen 4 jedoch freilassen.

Durch Pfeile 6 ist noch die Röntgenstrahlung dargestellt, die auf dem Szintillator 1 auftrifft. Die Fiberoptiken 2 dienen auch zur Abschirmung der Bildwandler 3 gegen die Röntgenstrahlung. Die Bildwandler 3 decken ein relativ großes Bildfeld ab, so daß auch relativ große Objekte aufgenommen werden können. Sie können in einer Reihe, aber auch als Matrix von z.B. vier Bildwandlern angeordnet sein.

Die Fig. 2 zeigt eine Ausführungsform, bei der die linke Fiberoptik 2 in Fig. 1 durch eine Fiberoptik 5 ersetzt ist, welche senkrecht zu den Bildwandlern 3 verläuft, d.h. im Gegensatz zur Fiberoptik 2 unter einem Winkel von 90° zu dem Bildwandler 3 liegt. Auch bei dieser Lösung sind die Randzonen 4 der Bildwandler 3 freigelassen.

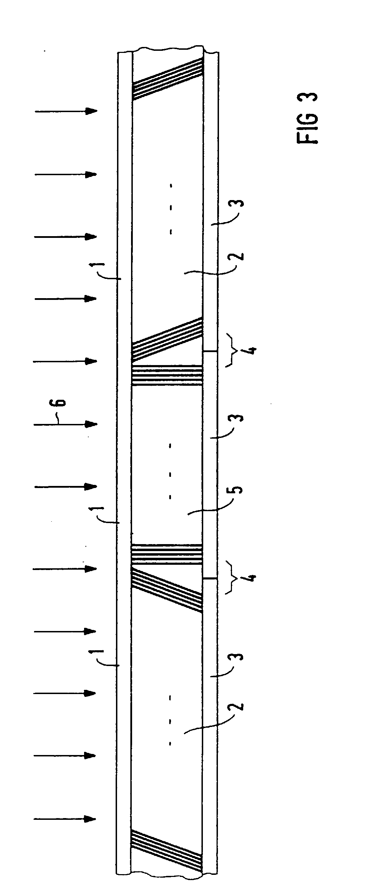

Schließlich zeigt die Fig. 3 eine Lösung, bei der drei Fiberoptiken 2, 5, 2 aufeinanderfolgen, entsprechend der Aufeinanderfolge von drei Bildwandlern 3.

Ein Röntgenbildsensor der beschriebenen Art eignet sich besonders für die Mammographie.

## Patentansprüche

1. Röntgenbildsensor mit mehreren, in mindestens einer Kante aneinander angrenzenden, flächenhaften Bildwandlern (3), die optisch nicht aktive Randzonen (4) aufweisen und über Fiberoptiken (2) an einem Szintillator (1) angekoppelt sind, wobei die Fiberoptiken (2) unter einem von 90° abweichenden Winkel gegenüber den Bildwandlern (3) geneigt sind, derart, daß sie am Szintillator (1) aneinander angrenzen, an den Bildwandlern (3) jedoch an der Koppelstelle zweier aneinander angrenzender Bildwandler (3) die optisch nicht aktiven Randzonen (4) freilassen.

2. Röntgenbildsensor nach Anspruch 1, bei dem die Fiberoptiken (2) aus Bündeln paralleler Fasern bestehen, deren Schnittwinkel zwischen der Fiberoptik-Eingangsoberfläche und der Faserachse von 90° abweicht.

3. Röntgenbildsensor nach Anspruch 1 oder 2, bei dem außer der oder den schrägen Fiberoptiken (2) auch mindestens eine Fiberoptik (5) vorhanden ist, die senkrecht zu den Bildwandlern (3) verläuft.

4. Röntgenbildsensor nach Anspruch 3, bei dem mindestens zwei schräge Fiberoptiken (2) eine senkrecht zu den Bildwandlern (3) verlaufende Fiberoptik (5) einfassen.

## Claims

1. X-ray image sensor having several planar image converters (3) adjoining each other at at least one edge, which image converters have optically inactive edge zones (4) and are coupled to a scintillator (1) by way of fibre optical systems (2), whereby the fibre optical systems (2) are inclined relative to the image converters (3) at an angle deviating from 90° in such a way that they adjoin each other at the scintillator (1), but at the image converters (3), at the coupling point of two image converters (3) which adjoin each other, leave the optically inactive edge zones (4) free.

2. X-ray image sensor according to claim 1, where the fibre optical systems (2) comprise bundles of parallel fibres, the intersection angle of which between the input surface of the fibre optical system and the fibre axis deviates from 90°.

3. X-ray image sensor according to claim 1 or 2, where apart from the inclined fibre optical system or systems (2), there is also at least one fibre optical system (5) which extends at right angles to the image converters (3).

4. X-ray image sensor according to claim 3, where at least two inclined fibre optical systems (2) enclose a fibre optical system (5) which extends at right angles to the image converters (3).

## Revendications

1. Capteur d'image de rayons X, comportant plusieurs transformateurs (3) d'image à grande surface, qui sont contigus les uns aux autres par au moins un bord, ces transformateurs comportant des zones (4) de bord optiquement inactives et étant couplés à un scintillateur (1) par des optiques (2) à fibres, les optiques (2) à fibres étant inclinées d'un angle différent de 90° par rapport aux transformateurs (3) d'image, de sorte qu'ils sont contigus au scintillateur (1), tout en laissant sur les transformateurs (3) d'image, au point de couplage de deux transformateurs (3) d'image contigus l'un à l'autre, dégagées les zones (4) de bord optiquement inactives.

2. Capteur d'image de rayons X suivant la revendication 1, dans lequel les optiques (2) à fibres sont constituées de faisceaux de fibres parallèles, dont l'angle de coupe entre la surface supérieure d'entrée d'optique à fibres et l'axe de fibres est différent de 90°.

3. Capteur d'image de rayons X suivant la revendication 1 ou 2, dans lequel en plus de l'optique (2) à fibre inclinée ou des optiques (2) à fibres inclinées, est également prévue au moins une optique (5) à fibres, qui s'étend perpendiculairement aux transformateurs (3) d'image.

4. Capteur d'image de rayons X suivant la revendication 3, dans lequel au moins deux optiques (2) à fibres inclinées comportent une optique (5) à fibres, s'étendant perpendiculairement aux transformateurs (3) d'image.
